# EUROPÄISCHE PATENTSCHRIFT

(11) **EP 0 627 875 B1**
(45) Veröffentlichungstag und Bekanntmachung des Hinweises auf die Patenterteilung: **10.04.1996**
(21) Anmeldenummer: 94107902.2
(22) Anmeldetag: 21.05.1994
(51) Int. Cl.: H05K 3/40, H01L 21/48

(54) **Verfahren zum Herstellen eines Metall-Keramik-Substrates**
Process for manufacturing metal-ceramic substrate
Procédé de fabrication d'un substrat métal-céramique

(30) Priorität: 01.06.1993 DE 4318061
(43) Veröffentlichungstag der Anmeldung: 07.12.1994
(73) Patentinhaber: Schulz-Harder, Jürgen, Dr.-Ing., D-91207 Lauf (DE); Maier, Peter, D-91207 Lauf (DE)
(72) Erfinder: Schulz-Harder, Jürgen, Dr.-Ing., D-91207 Lauf (DE); Maier, Peter, D-91207 Lauf (DE)
(74) Vertreter: Graf, Helmut, Dipl.-Ing.

(56) Entgegenhaltungen:
- EP-A- 0 227 066
- EP-A- 0 299 136
- DE-A- 4 103 294

## Beschreibung

Die Erfindung bezieht sich auf ein Verfahren zum Herstellen eines Keramik-Metall-Substrates und dabei speziell zum Herstellen eines solchen Substrates mit wenigstens einer Durchkontaktierung.

Es ist bekannt, Metall-Keramik-Substrate, die an einer oder an beiden Oberflächenseiten einer Keramikschicht jeweils eine Metallschicht, beispielsweise eine Kupferschicht aufweisen, mittels der sog. Direct-Bonding-Technik (DGB-Technik oder -Verfahren) herzustellen, die bei Metallschichten aus Kupfer auch als Direct-Copper-Bonding-Technik bzw. DGB-Technik oder -Verfahren bezeichnet wird. Bei diesem beispielsweise in der US-PS 37 44 120 oder DE-PS 23 19 854 beschriebenen Verfahren wird die Verbindung zwischen der Keramikschicht und einer die jeweilige Metallschicht bildenden Metallfolie oder -platine dadurch hergestellt, daß die Platine an ihren Oberflächen eine Schicht oder einen Überzug (Aufschmelzschicht) aus einer chemischen Verbindung aus dem Metall und einem reaktiven Gas, bevorzugt Sauerstoff, aufweist, und daß nach dem Auflegen der Metallfolie oder -platine auf eine Oberflächenseite der Keramikschicht diese Anordnung aus Keramik und Metall auf eine Prozeßtemperatur erhitzt wird, die oberhalb der eutektischen Temperatur der chemischen Verbindung zwischen Metall und reaktivem Gas, aber unterhalb der Schmelztemperatur des Metalls liegt, so daß an der Außenfläche der Metallfolie bzw. -platine (an der Aufschmelzschicht) eine flüssige Phase entsteht, über die dann die Verbindung mit dem Keramik erfolgt.

In der elektrischen Schaltungstechnik werden vielfach Durchkontaktierungen benötigt, die elektrische Verbindungen beispielsweise zwischen Leiterbahnen, Kontaktflächen usw. aus zwei unterschiedlichen Seiten eines Substrates herstellen. Derartige Durchkontaktierungen sind z.B. in der Leiterplattentechnik üblich und werden dort beispielsweise auf chemischen und/oder galvanischen Wegen durch Kupfer oder andere geeignete Materialien erzeugt. Diese Technik ist auf relativ gering Stromwerte begrenzt und insbesondere für Leistungsschaltkreise mit hohen Strömen wenig geeignet.

Aus der Hybridtechnik ist bekannt (DE-PS 34 34 449), zur Herstellung von Leiterbahnen Leit- oder Siebdruckpasten zu verwenden, die ein Metall und ein Bindemittel enthalten und die nach dem Auftragen auf ein Substrat und nach dem Einbrennen bei einer Temperatur zwischen 600 - 900^{o}C Leiterbahnen aus dem Substrat bilden. Diese Pasten können beim Auftragen auch in im Substrat vorgesehene Verbindungskanäle oder Fenster eingepreßt werden, so daß auf diese Weise Durchkontaktierungen erhalten werden.

Nachteilig ist hier die geringe Leitfähigkeit der mit diesen Pasten hergestellten elektrischen Leiterbahnen und Verbindungen bzw. Durchkontaktierungen. Diese in der Hybridtechnik verwendeten Leitpasten müssen in der Regel unter Luft eingebrannt werden. Für die Herstellung von Metall-Keramik-Substraten mittels der DCB-Technik sind diese Pasten daher nicht geeignet, da das DCB-Verfahren in einer Schutzgasatmosphäre durchgeführt werden muß. Weiterhin unterscheidet sich auch der Wärmeausdehnungskoeffizient einer eingebrannten Leit- bzw. Siebdruckpaste wesentlich von dem Wärmeausdehnungskoeffizienten einer massiven Metallschicht. Da gerade Metall-Keramik-Substrate für elektrische Leistungsschaltkreise bzw. -module verwendet werden und dort sehr häufigen Temperaturlastwechseln bei extremen Temperaturunterschieden ausgesetzt sind, sind derartige Siebdruckpasten für Durchkontaktierungen bei Keramik-Metall-Substraten, die nach dem DCB-Verfahren hergestellt sind, grundsätzlich nicht geeignet.

Bekannt ist schließlich auch ein Verfahren (DE-PS 41 03 294), welches speziell zum Herstellen von Durchkontaktierungen mittels des DCB-Verfahrens bestimmt ist. Bei diesem bekannten Verfahren wird in die jeweilige, für die Durchkontaktierung vorgesehene Öffnung der Keramikschicht ein Metallpulver, bevorzugt ein Kupferpulver eingebracht, welches während des DCB-Verfahrens aufschmelzen und sich mit den Metallschichten verbinden soll, um so eine elektrisch leitfähige, die Metallschichten an den beiden Oberflächenseiten einer Keramikschicht verbindende Brücke zu bilden. Nachteilig bei diesem bekannten Verfahren ist insbesondere, daß das angestrebte Ergebnis sich nur bei einer extrem genauen Prozeßführung erreichen läßt, insbesondere läßt sich nur bei einer extrem genauen Prozeßführung sicherstellen, daß die angestrebte Durchkontaktierung bzw. Verbindung mit dem erforderlichen Querschnitt tatsächlich auch an beiden Metallschichten erfolgt. Nachteilig bei diesem bekannten Verfahren ist weiterhin auch, daß der wirksame Querschnitt der Durchkontaktierung und damit die Leitfähigkeit dieser Kontaktierung bei vorgegebener Größe der Öffnung bzw. des Fensters begrenzt sind. Da sich die Durchkontaktierung bzw. die Brücke grundsätzlich hülsen- oder hohlzylinderartig ausbildet, der elektrisch wirksame Querschnitt dieser Brücke also nur einen Bruchteil des Fensterquerschnittes beträgt.

Aufgabe der Erfindung ist es, ein Verfahren aufzuzeigen, mit welchem problemlos die Herstellung von Metall-Keramik-Substraten mit wenigstens einer Durchkontaktierung nach dem DCB-Verfahren möglich ist.

Zur Lösung dieser Aufgabe ist ein Verfahren entsprechend dem kennzeichnenden Teil des Patentanspruches 1 ausgebildet.

Bei dem erfindungsgemäßen Verfahren wird zur Herstellung der Durchkontaktierung in die Öffnung bzw. in das Fenster der Keramikschicht ein massiver Metallkörper eingesetzt, der an seiner Oberfläche ebenfalls die chemische Verbindung aus dem Metall und dem reaktiven Gas (Aufschmelzschicht) aufweist und der somit mittels des DCB-Verfahrens mit dem die Metallschichten bildenden Metallfolien oder -platinen verbunden werden kann, so daß dieser Metallkörper dann eine elektrisch leitende Brücke mit einem wirksamen Querschnitt bildet, der gleich oder nahezu gleich dem Querschnitt der Öffnung bzw. des Fensters in der Keramikschicht ist.

Die Metallkörper können preiswert und einfach z.B. durch Stanzen (beispielsweise Zylinder) und nachträgliches Mühlenschleifen (beispielsweise Kugeln) hergestellt werden.

Die von der chemischen Verbindung aus dem Metall und dem reaktiven Gas hergestellte Aufschmelzschicht besitzt beispielsweise an den Metallfolien bzw. -platinen und an den Metallkörpern eine Dicke von 5 - 30 Mikrometer.

Die Vorteile des erfindungsgemäßen Verfahrens sind u.a. eine unproblematische Prozeßführung, die Sicherstellung einer zuverlässigen Durchkontaktierung mit großem wirksamen Querschnitt und damit mit hoher Leitfähigkeit sowie auch eine hermetische Abdichtung der Durchkontaktierung an beiden über diese Kontaktierung verbundenen Metallschichten.

Im einfachsten Fall besteht das mit dem erfindungsgemäßen Verfahren hergestellte Metall-Keramik-Substrat aus einer Keramikschicht, die an ihren beiden Oberflächenseiten jeweils mit wenigstens einer Metallschicht versehen ist. Grundsätzlich ist es aber auch möglich, mit dem erfindungsgemäßen Verfahren Metall-Keramik-Substrate herzustellen, die zwei oder mehr als zwei Keramik-Schichten mit jeweils dazwischen angeordneten Metallschichten aufweisen, wobei dann im Bereich wenigstens einer Keramikschicht zumindest eine Durchkontaktierung vorgesehen ist.

Weist das Metall-Keramik-Substrat mehrere Keramikschichten mit jeweils mindestens einer Durchkontaktierung auf, so werden diese Kontaktierungen durch Einsetzen der Metallkörper in die jeweiligen Öffnungen bzw. Fenster in einem gemeinsamen Verfahrensschritt, oder aber sukzessive in mehreren aufeinanderfolgenden Verfahrensschritten hergestellt.

Weiterbildungen der Erfindung sind Gegenstand der Unteransprüche.

Die Erfindung wird im folgenden anhand der Figuren an Ausführungsbeispielen näher erläutert. Es zeigen:
- Fig. 1: in vergrößerter Teildarstellung ein Keramik-Substrat mit einer nach dem erfindungsgemäßen Verfahren hergestellten Durchkontaktierung;
- Fig. 2 bis 7: verschiedene Verfahrensschritte beim Herstellen des Keramik-Substrats mit der wenigstens einen Durchkontaktierung.
- Fig. 8 bis 10: in einer Darstellung wie Fig. 1 weitere nach der Erfindung hergestellte Substrate.

In den Figuren ist 1 ein Keramik-Substrat für einen elektrischen Schaltkreis, vorzugsweise für einen Leistungs-Schaltkreis oder ein Leistungs-Modul. Das Substrat 1 besteht bei der dargestellten Ausführungsform aus einer Keramik-Schicht 2, die beispielsweise eine Aluminiumoxid-Keramik oder aber eine Aluminiumnitrid-Keramik ist. Auf beiden Oberflächenseiten der Keramikschicht ist jeweils eine Kupferschicht 3 bzw. 4 aufgebracht, und zwar in der sog. DCB-Technik (Direct Copper-Bonding-Technik), die dem Fachmann grundsätzlich bekannt ist.

Im Bereich einer Durchkontaktierung 5 ist in der Keramiks chicht 2 eine Ausnehmung oder Öffnung 6 vorgesehen, durch die die beiden Kupferschichten 3 und 4 über eine massive Brücke 7 aus Kupfer miteinander verbunden sind. Letztere ist so ausgeführt, daß sie einen homogenen Kupferquerschnitt bildet, der in etwa gleich dem Querschnitt der Öffnung 6 ist.

Über die Brücke 7 wird eine elektrische Verbindung zwischen den in der Regel strukturierten Kupferschichten 3 und 4 bzw. zwischen den von diesen Kupferschichten gebildeten Leiterbahnen, Kontaktflächen usw. hergestellt.

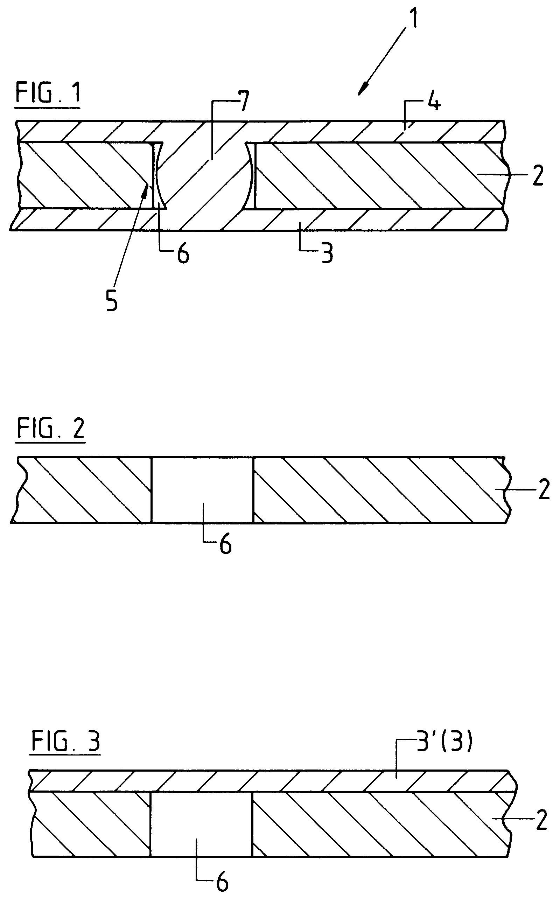

Die Fig. 2 bis 5 zeigen im Prinzip die Verfahrensschritte zum Herstellen des Substrates 1.

In einem ersten Verfahrensschritt wird zunächst in die Keramikschicht 2 die wenigstens eine Öffnung 6 eingebracht, beispielsweise durch Stanzen (der Grünfolien), Laserschneiden oder auf eine andere, geeignete Weise. Im Anschluß daran wird auf einer Oberflächenseite der mit der Öffnung 6 versehenen Keramikschicht 2 eine der beiden Kupferschichten, beispielsweise die in der Fig. 1 untere Kupferschicht 3 aufgebracht. Hierfür wird auf eine Oberflächenseite der Keramikschicht 2 eine Kupferplatine 3' aufgelegt, die an ihren Oberflächenseiten voroxidiert ist. Anschließend wird die in der Fig. 3 dargestellte Anordnung in einer Schutzgasatmosphäre auf eine Prozeßtemperatur aufgeheizt, die oberhalb der eutektischen Temperatur des Systems Kupfer-Sauerstoff, aber unterhalb der Schmelztemperatur des Kupfers der Kupferplatine 3' ist, und auf dieser Prozeßtemperatur für eine bestimmte Zeitdauer gehalten, so daß die gewünschte Verbindung zwischen der Keramikschicht 2 (Aluminiumoxidkeramik) und der Kupferplatine 3' erreicht wird.

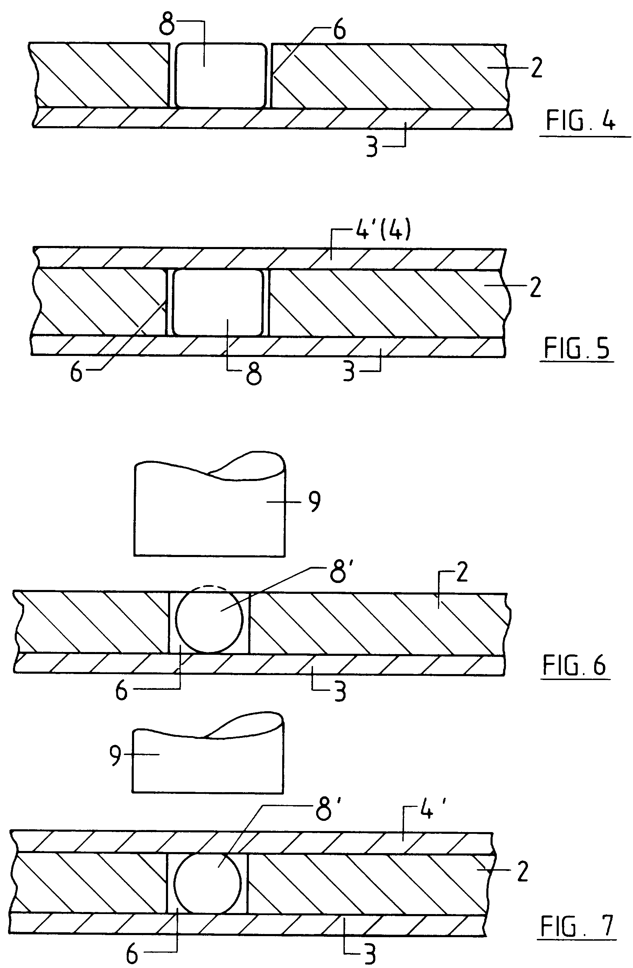

Nach dem Abkühlen des so erhaltenen Zwischenproduktes, bestehend aus der Keramikschicht 2 und der an der einen Oberflächenseite der Keramikschicht vorgesehenen Kupferschicht 3, wird das Zwischenprodukt gewendet und in die dann oben offene Ausnehmung 6 wird entsprechend der Fig. 4 ein die spätere Brücke 7 bildender massiver Kupferkörper 8 eingesetzt. Bei der in den Figuren 4 und 5 dargestellten Ausführungsform ist dieser Kupferkörper rondenartig ausgeführt.

Der Kupferkörper 8 wurde von dem Einsetzen in der Ausnehmung 6 in einem weiteren, nicht dargestellten Verfahrensschritt in einer Sauerstoff enthaltenden Atmosphäre, beispielsweise in Luft, durch Erhitzen auf eine Voroxidationstemperatur, beispielsweise auf eine Temperatur von 450^{o}C, an seiner gesamten Oberfläche oxidiert. Die Voroxidation kann auch naßchemisch erfolgen, beispielsweise in handelsüblichen Schwarzoxidbädern. Nach seiner Voroxidation erfolgt das Einlegen des Kupferkörpers 8 in die jeweilige Ausnehmung 6.

Ist das Substrat 1 mit mehreren Durchkontaktierungen 5 zu versehen und besitzt dementsprechend die Keramikschicht 2 eine Vielzahl von Öffnungen 6, in die jeweils ein Kupferkörper 8 eingesetzt werden soll, so kann dieses Einsetzen in besonders rationeller Weise und dabei insbesondere auch in einer Vorrichtung dadurch erfolgen, daß auf die in einer horizontalen Ebene oder in einer im wesentlichen horizontalen Ebene angeordnete Oberseite der Keramikschicht 2, die an dieser Oberseite die offenen Öffnungen 6 besitzt und an ihrer Unterseite die Kupferschicht 3 aufweist, eine bestimmte Menge an Kupferkörper 8 aufgeschüttet wird. Durch eine geeignete Technik, beispielsweise durch Schütteln und/oder Vibrieren und/oder durch eine andere, geeignete Bewegung der Keramikschicht 2 oder eines diese Schicht tragenden Trägers oder Tisches werden dann die aufgeschütteten Kupferkörper 8 so verteilt, daß sich in jeder Öffnung 6 ein derartiger Kupferkörper befindet. Diese Verteilung bzw. dieses Einbringen der Kupferkörper 8 in die Öffnungen 6 kann auch durch schaber- oder besenartige Elemente erfolgen oder unterstützt werden, die über die Oberseite der Keramikschicht 2 bewegt werden.

Im Anschluß daran werden diejenigen Kupferkörper 8, die nicht von einer Ausnehmung 6 aufgenommen sind, entfernt, und zwar beispielsweise durch Neigen der Keramikschicht 2 und/oder durch besen- oder schieberartige Abstreifelemente und/oder durch Abblasen usw.

Die Kupferkörper 8 sind mit ihren Abmessungen so gewählt und an die Dicke der Keramikschicht 2 angepaßt, daß jeder in einer Öffnung 6 aufgenommene Kupferkörper 8 mit seiner Oberseite bündig mit der Oberseite der Keramikschicht 2 liegt, wie dies in der Fig. 4 dargestellt ist.

In einem nächsten Verfahrensschritt wird eine die spätere Kupferschicht 4 bildende Kupferplatine 4' aufgelegt, die ebenfalls vorher an ihren Oberflächenseiten voroxidiert wurde, und zwar wiederum beispielsweise in Luft bei einer Voroxidationstemperatur von etwa 450^{o}C. Nach dem Auflegen der Kupferplatine 2' erfolgt eine erneute Erhitzung der Anordnung in einer Schutzgasatmosphäre auf die Prozeßtemperatur, die wiederum oberhalb der eutektischen Temperatur des Kupferoxides, aber unterhalb der Schmelztemperatur des Kupfers der Kupferplatine 4' ist. Diese Prozeßtemperatur liegt beispielsweise in der Größenordnung von etwa 1070 bis 1075^{o}C. Nachdem die Prozeßtemperatur über eine vorgegebene Zeitperiode aufrechterhalten worden ist, die sowohl für die Herstellung der flächigen Verbindung zwischen der Kupferplatine 4' und der Keramikschicht 2 als auch für eine flächige Verbindung zwischen dem Kupferkörper 8 und den Kupferplatinen 3' und 4' bzw. den entsprechenden Kupferschichten ausreichend lang gewählt ist, wird das erhaltene Produkt bzw. Substrat 1 abgekühlt.

Bei der vorbeschriebenen Ausführungsform wurde davon ausgegangen, daß die Kupferkörper 8, die durch Stanzen aus einem geeigneten Kupfermaterial (Kupferblech) besonders einfach hergestellt werden können, eine rondenartige Form aufweisen. Selbstverständlich ist es auch möglich, für diese Kupferkörper 8 eine andere Formgebung zu wählen, beispielsweise können diese Kupferkörper quaderförmig ausgeführt sein.

Besonders vorteilhaft sind aber Kupferkörper 8' in Kugelform, die sich besonders leicht durch Rüttel- bzw. Vibrationstechnik auf die einzelnen Öffnungen 6 verteilen lassen.

Die Fig. 6 und 7 zeigen solche als Kugeln ausgebildete Kupferkörper 8' bei weiteren grundsätzlichen Abwandlungen des erfindungsgemäßen Verfahrens.

Bei dem in der Fig. 6 dargestellten abgewandelten Verfahren werden die kugelförmigen, an ihrer Oberfläche selbstverständlich wiederum voroxidierten kugelförmigen Kupferkörper 8 deren Durchmesser etwas größer ist als die Dicke der Keramikschicht 2, nach dem Einsetzen in die jeweilige Öffnung 6 durch einen Stempel 9 derart flachgedrückt, daß der Kupferkörper 8' dann die erforderliche Höhe aufweist.

Das Flachdrücken des Kupferkörpers 8' erfolgt bei in die jeweilige Öffnung 6 eingesetztem Kupferkörper, der mit seiner Unterseite auf der Kupferplatine 3' bzw. auf der von dieser Platine gebildeten Kupferschicht 3 aufliegt.

Fig. 7 zeigt schematisch eine weitere Abwandlung des Herstellungsverfahrens. Für die Durchkontaktierung 5 werden wiederum kugelförmige Kupferkörper 8' verwendet. Das Flachdrücken des jeweiligen Kupferkörpers 8' erfolgt nach dem Auflegen der Kupferplatine 4' auf die Oberfläche der Keramikschicht 2 und vor dem Bonden der Kupferplatine 4', und zwar wiederum mit Hilfe des Stempels 9.

Abweichend von den in den Fig. 6 und 7 dargestellten Verfahren ist es auch möglich, die Kupferkörper 8 bzw. 8' außerhalb der Öffnungen 6 in einem Form- und Kalibierwerkzeug durch bleibende Verformung in der Höhe an die Dicke der Keramikschicht 2 exakt anzupassen.

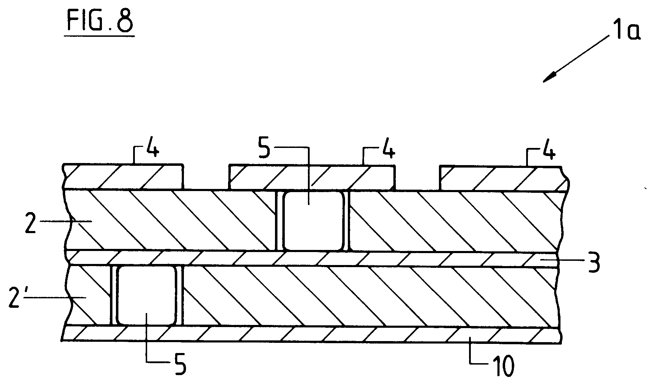

Das Verfahren kann auch so ausgebildet sein, daß mit ihm ein mehrere Keramikschichten 2 aufweisendes Multilayer-Substrat hergestellt wird, welches wenigstens eine massive Durchkontaktierung aufweist, wobei die Keramikschichten auch aus unterschiedlichen Keramiken bestehen können. Weiterhin kann das Substrat auch so hergestellt sein, daß es unabhängig von der Anzahl der Keramikschichten und/oder Durchkontaktierungen usw. herausgeführte Anschlüsse besitzt. Die wenigstens eine Durchkontaktierung kann auch als Wärmebrücke dienen, beispielsweise zur Wärmeableitung von einer Metallschicht auf eine weitere Metallschicht. Diese entsprechenden Ausführungen bzw. Abwandlungen sind in den Figuren 8 - 10 dargestellt.

Fig. 8 zeigt ein Multilayer-Substrat 1a, welches aus zwei Lagen besteht, und zwar aus einer oberen Lage, die die Keramikschicht 2, die beispielsweise eine Aluminiumoxid-Keramik ist, die obere, strukturierte Kupferschicht 4 sowie die untere, ebenfalls strukturierte Kupferschicht 3 umfaßt. Das Multilayer-Substrat 1a besteht weiterhin aus einer zweiten Lage, die eine zweite Keramikschicht 2' sowie eine Kupferschicht 10 umfaßt. Letztere ist flächig mit der unteren Oberflächenseite der Keramikschicht 2' verbunden. Die Oberseite der Keramikschicht 2', die beispielsweise eine Aluminiumnitrid-Keramik ist, ist flächig mit der Unterseite der unteren Kupferschicht 3 verbunden, so daß letztere eine mittlere Kupferschicht, d.h. eine im Substrat zwischen den Keramikschichten 2 und 2' angeordnete Kupferschicht bilden. Das Substrat 1a besitzt wenigstens zwei Durchkontaktierungen 5, und zwar jeweils eine zwischen der Kupferschicht 3 und der oberen Kupferschicht 4 bzw. unteren Kupferschicht 10.

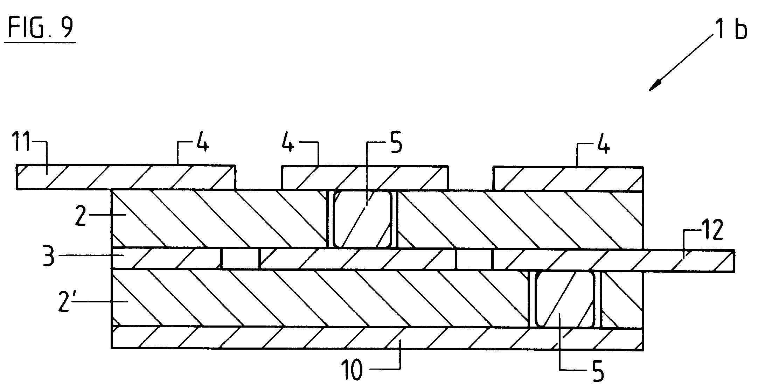

Fig. 9 zeigt in ähnlicher Darstellung wie Fig. 8 ein Multilayer-Substrat 1b, welches sich von dem Multilayer-Substrat 1a der Fig. 8 im wesentlichen dadurch unterscheidet, daß die obere Kupferschicht 4 sowie die Kupferschicht 3 jeweils aus dem Substrat seitlich herausgeführte Anschlüsse 11 bzw. 12 bilden.

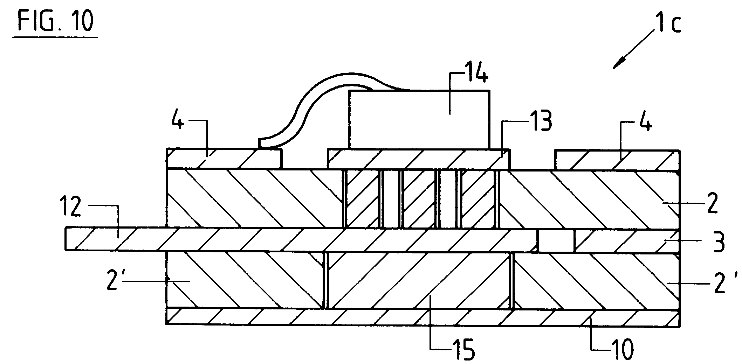

Fig. 10 zeigt in ähnlicher Darstellung ein Multilayer-Substrat 1c, bei dem die obere, strukturierte Kupferschicht 4 bei 13 eine Kontaktfläche bildet, auf der ein Leistungs-Halbleiter-Element 14 angeordnet ist. Ansonsten bildet die obere strukturierte Kupferschicht 4 zumindest teilweise Leiterbahnen, die u.a. zur Ansteuerung des Leistungs-Bauelementes 14 dienen, teilweise aber auch Bestandteil des Ausgangs- oder Leistungsstromkreises dieses Bauelementes sind.

Die Kupferschicht 3 weist wiederum den Anschluß 12 auf und ist ebenfalls Bestandteil des Ausgangs- bzw. Leistungsstromkreises des Bauelementes 14. Hierfür ist die Kupferschicht 3 durch mehrere Durchkontaktierungen 5 mit der Kontaktfläche 13 elektrisch verbunden ist.

Die Keramikschicht 2' besteht unterhalb der Kontaktfläche 13 aus einer Aluminium-Nitrid-Keramik, die einen hohen Wärmeleitwert aufweist. Dieser Bereich ist mit 15 angegeben. Ansonsten besteht die Keramikschicht 2' aus Aluminium-Oxid-Keramik. Über die Kupferschicht 10 ist das Multilayer-Substrat 1c bzw. das von diesem Substrat gebildete Leistungsmodul mit einer nicht dargestellten Trägerplatte aus Kupfer verbunden, die ihrerseits an einem Kühlkörper zum Ableiten der Verlustwärme des Leistungsbauelementes 14 befestigt ist. Die Durchkontaktierungen 5 dienen bei dem Multilayer-Substrat 1c sowohl als elektrische Verbindungen, als auch Wärmeleitbrücken, um die Verlustwärme des Bauelementes 14 von der Kontaktfläche 13 auf die Kupferschicht 3 zu übertragen, von der Verlustwärme über den Bereich 15 an die Kupferschicht 10 abgeleitet wird.

Nachfolgend wird an einigen Beispielen die Herstellung des Substrates 1 mit wenigstens einer Durchkontaktierung 5 näher beschrieben:

### Beispiel 1

1. Voroxidation der ersten Kupferplatine, beispielsweise der Kupferplatine 3' mit einer Dicke von 0,3 mm während 8 Min. bei 450^{o}C in Luft;
2. Auflegen der voroxidierten Kupferplatine 3' auf die Keramikschicht 2 aus Al₂O₃-Keramik mit einer Dicke von 0,63 mm und mit Löchern bzw. Öffnungen 6 mit einem Durchmesser von 1,1 mm;
3. Erhitzen der mit der Kupferplatine 3' versehenen Keramikschicht 2 in einer Stickstoffatmosphäre mit 5 ppmO₂-Gehalt über eine Zeitdauer von 15 Min. auf eine Prozeßtemperatur von 1072^{o}C;
4. Halten der Keramikschicht 2 und der Kupferplatine 3' bei der Prozeßtemperatur von 1072^{o}C über eine Zeitdauer von 2 Min.;
5. Abkühlung des Zwischenproduktes innerhalb 15 Min.;
6. Voroxidation des rondenförmigen und einen Querschnitt von 1 mm aufweisenden Kupferkörpers 8 bei 450^{o}C in Luft und über eine Zeitdauer von 8 Min. zur Erzielung einer Kupferoxidschicht;
7. Voroxidation der zweiten Kupferplatine, beispielsweise der Kupferplatine 4' mit einer Dicke von 0,3 mm bei 450^{o}C in Luft über eine Zeitdauer von 8 Min.;
8. Einlegen der voroxidierten Kupferkörper 8 in jeweils eine Öffnung 6;
9. Auflegen der voroxidierten Kupferplatine 4' auf die Keramikschicht 2;
10. Erhitzen der Keramikschicht mit den Kupferplatinen in einer Stickstoffatmosphäre mit einem O₂-Gehalt von 5ppm auf 1072^{o}C innerhalb von 18 Min.;
11. Halten der Prozeßtemperatur von 1072^{o}C über eine Zeitdauer von etwa 2 Min.;
12. Abkühlen des Substrates 1 innerhalb einer Zeitdauer von 18 Min.

Das Ergebnis dieses Verfahrens war ein Substrat mit einer vollständigen Durchkontaktierung 5, d. h. mit einer vollständigen, homogenen Kupferverbindung oder -Anbindung sowohl im Bereich der Durchkontaktierung als auch am Übergang zwischen Kupfer und Keramik.

### Beispiel 2

Bei diesem Beispiel wurde anstelle des rondenförmigen Kupferkörpers ein Kupferkörper 8' verwendet in Form einer Kugel mit einem Durchmesser von 0,8 mm.

Die Verfahrensschritte 1-5 entsprechen bei diesem Beispiel den Verfahrensschritten 1-5 des Beispiels 1, wobei in dem 6. Verfahrensschritt die Voroxidation des als Kugel ausgebildeten Kupferkörpers 8' erfolgt, und zwar wiederum bei 450^{o}C in Luft und während einer Dauer von 8 Min.

Die Verfahrensschritte 7 und 8 entsprechen bei diesem Beispiel den Verfahrensschritten 7 und 8 des Beispiels 1.

Als 9. Verfahrensschritt erfolgt das Verformen oder Fressen des kugelförmigen Kupferkörpers 8' auf eine Höhe von 0,7 mm.

Als weitere Verfahrensschritte 10-13 schließen sich dann die Verfahrensschritte 9-12 des Beispiels 1 an.

Das erfindungsgemäße Verfahren ist nicht nur auf Aluminiumoxi d-Keramiken, sondern auch auf andere Keramiken anwendbar.

### Beispiel 3

Bei diesem Beispiel wurde eine Keramikschicht 2 aus einer Aluminiumnitrid-Keramik verwendet.
1. Als erster Verfahrensschritt erfolgte wieder die Voroxidation einer der beiden Kupferplatinen, beispielsweise der Kupferplatine 3' mit einer Dicke von 0,3 mm bei 450^{o}C in Luft während einer Zeitdauer von 8 Min.
2. Oxidation der Keramikschicht 2 aus Aluminiumnitrid-Keramik bei 1200^{o}C in Luft während einer Zeitdauer von 1 Std.
3. bis 14. Diese Verfahrensschritte entsprechen dann den Verfahrensschritten 2-13 des Beispiels 2.

### Beispiel 4

Bei diesem Beispiel erfolgte die Herstellung eines Multilayer-Substrats.
1. - 13. Verfahrensschritte 1 - 13 des Beispiels 3;
14. Ätzen des Layouts der ersten Schicht;
15. Oxidation des Substrats mit dem geätzten Layout;
16. - 21. Herstellung der zweiten Lage entsprechend den Verfahrensschritten 1 - 5 des Beispiels 1 unter Verwendung der Keramikschicht 2';
22. Voroxidation eines rondenförmigen Kupferkörpers 8;
23. Einlegen des Kupferkörpers 8 in eine Öffnung 6 der Keramikschicht 2';
24. Auflegen der nach den Verfahrensschritten 1 - 15 hergestellten ersten Lage.
25. Erhitzen der beiden Lagen in einer Schutzgas-Atmosphäre, beispielslweise Stickstoff-Atmosphäre mit einem 02-Gehalt von 5 ppm auf 1072° C innerhalb von 18 Minuten.
26. Halten der Prozeßtemperatur von 1072° C innerhalb eine Zeitdauer von etwa 2 Minuten.
27. Abkühlen des Multilayer-Substrates la - lc innerhalb einer Zeitdauer von 18 Minuten.

Die Erfindung wurde voranstehend an Ausführungsbeispielen beschrieben. Es versteht sich, daß Änderungen sowie Abwandlungen möglich sind, ohne daß dadurch der der Erfindung zugrundeliegende Erfindungsgedanke verlassen wird.

### Bezugszeichenliste

1 Substrat
2 Keramikschicht
2' Keramik
3 Kupferschicht
3' Kupferplatine
4 Kupferschicht
4' Kupferplatine
5 Durchkontaktierung
6 Öffnung
7 Kupferbrücke
8, 8' Kupferkörper
9 Stempel
10 Kupferschicht
11, 12 Anschluß
13 Kontaktfläche
14 Bauelement
15 Bereich

## Patentansprüche

1. Verfahren zum Herstellen eines Keramik-Metall-Substrates, welches aus wenigstens einer Keramikschicht (2) sowie aus wenigstens zwei, an jeweils einer Oberflächenseite der Keramikschicht (2) vorgesehenen Metallschichten (3, 4) besteht und wenigstens eine elektrische Durchkontaktierung (5) aufweist, an der die Metallschichten (3, 4) im Bereich einer Öffnung oder eines Fensters (6) in der wenigstens einen Keramikschicht (2) durch eine Brücke (7) aus Metall elektrisch miteinander verbunden sind, bei welchem (Verfahren) Metallfolien oder -platinen (3', 4'), deren Oberflächen von einer chemischen Verbindung des Metalls mit einem reaktiven Gas gebildet sind, mittels des Direct-Bonding-Verfahrens an den Oberflächenseiten der wenigstens einen Keramikschicht (2) zur Bildung der Metallschichten (3, 4) befestigt werden, und bei welchem (Verfahren) zur Herstellung der Durchkontaktierung (5) in die wenigstens eine Öffnung bzw. in das wenigstens eine Fenster (6) ein die Brücke (7) bildendes Metall eingebracht wird, über welches die Metallschichten (3, 4) mittels des Direct-Bonding-Verfahrens miteinander elektrisch verbunden werden, dadurch gekennzeichnet, daß in die wenigstens eine Öffnung (6) ein diese vollständig oder nahezu vollständig ausfüllender Metallkörper (8, 8') eingesetzt wird, welcher an seiner Oberfläche ebenfalls mit einer Schicht aus der chemischen Verbindung aus dem Metall und dem reaktiven Gas versehen ist.

2. Verfahren nach Anspruch 1, dadurch gekennzeichnet, daß beim Befestigen wenigstens einer Metallfolie oder -platine (3', 4') zugleich auch die Verbindung des Metallkörpers (8, 8') mit wenigstens einer der beiden Metallschichten (3, 4) erfolgt.

3. Verfahren nach Anspruch 1 oder 2, dadurch gekennzeichnet, daß auf der einen Oberflächenseite der Keramikschicht (2) zunächst eine eine erste Metallschicht (3) bildende Metallfolie oder -platine (3') befestigt wird, daß anschließend der wenigstens eine Metallkörper (8, 8') in das wenigstens eine Fenster bzw. in die wenigstens eine Öffnung (6) von der anderen Oberflächenseite der Keramikschicht (2) her eingesetzt wird, daß dann auf diese andere Oberflächenseite der Keramikschicht (2) wenigstens eine die zweite Metallschicht (4) bildende Metallfolie oder -platine (4') aufgelegt wird, und daß dann in einem nochmaligen Direct-Bonding-Verfahren diese zweite Metallfolie oder -platine (4') mit der Keramikschicht (2) sowie zugleich der Metallkörper (8, 8') mit den Metallschichten (3, 4) an beiden Oberflächenseiten der Keramikschicht (2) verbunden wird.

4. Verfahren nach einem der Ansprüche 1 - 3, dadurch gekennzeichnet, daß bei mehreren Öffnungen oder Fenstern (6) in der Keramikschicht (2) zur Bildung von mehreren Durchkontaktierungen (5) in jedes Fenster (6) ein Metallkörper (8, 8') eingebracht wird, und zwar vorzugsweise durch eine Verteilung dieser Metallkörper auf die Öffnungen (6) mittels einer Rüttel- oder Vibrationstechnik und/oder unter Verwendung von Verteiler- oder Abstreifelementen.

5. Verfahren nach einem der Ansprüche 1 - 4, dadurch gekennzeichnet, daß das Metall Kupfer und/oder daß das reaktive Gas Sauerstoff ist.

6. Verfahren nach einem der Ansprüche 1 - 5, dadurch gekennzeichnet, daß die Metallkörper (8, 8') rondenartig, quaderförmig oder als Kugeln ausgebildet sind.

7. Verfahren nach einem der Ansprüche 1 - 6, dadurch gekennzeichnet, daß die Metallkörper (8, 8') in ihren Abmessungen derart gewählt sind, daß die Höhe der Metallkörper (8, 8') gleich oder geringfügig größer ist als die Dicke der Keramikschicht (2).

8. Verfahren nach einem der Ansprüche 1 - 7, dadurch gekennzeichnet, daß die Keramikschicht (2) eine Aluminiumoxid-Keramik oder eine Aluminiumnitrid-Keramik ist, die an ihren Oberflächenseiten voroxidiert ist.

9. Verfahren nach einem der Ansprüche 1 - 8, dadurch gekennzeichnet, daß der Metallkörper 8, 8') vor und/oder nach dem Einsetzen in ein Fenster (6) auf eine der Dicke der Keramikschicht (2) entsprechende Abmessung bleibend verformt wird.

10. Keramik-Metall-Substrat mit wenigstens einer Durchkontaktierung, gekennzeichnet durch seine Herstellung mit wenigstens einer massiven Durchkontaktierung unter Verwendung des Verfahrens nach einem der Ansprüche 1 bis 9.

## Claims

1. Process for the manufacture of a ceramic/metal substrate which comprises at least a single ceramic layer (2) and at least two metal layers (3, 4) provided on each surface side of the ceramic layer (2) and exhibits at least one electric through connection (5), to which the metal layers (3, 4) are electrically connected together in the area of an opening or a window (6) in the at least single ceramic layer (2) via a metal bridge (7), in which (process) metal foils or blanks (3', 4'), whose surfaces are formed by a chemical bond between the metal and a reactive gas, are fixed using the direct bonding process to the surface sides of the at least single ceramic layer (2) to form the metal layers (3, 4), and in which (process), in order to form the through connection (5), a metal forming the bridge (7), is inserted into the at least single opening or into the at least single window (6), via which bridge the metal layers (3, 4) are electrically connected together using the direct bonding process, characterised in that a metal body (8, 8') is inserted into the at least single opening (6), which fills it completely or virtually completely, and which is also provided on its surface with a layer from the chemical bond of the metal and the reactive gas.

2. Process according to claim 1, characterised in that when fixing at least one metal foil or blank (3', 4'), connection of the metal body (8, 8') with at least one of the two metal layers (3, 4) takes place at the same time.

3. Process according to claim 1 or 2, characterised in that a metal foil or blank (3') forming an initial metal layer (3) is fixed on one surface side of the ceramic layer (2), that subsequently the at least single metal body (8, 8') is inserted into the at least single window or into the at least single opening (6) from the other surface side of the ceramic layer (2), that then at least a single metal foil or blank (4') forming the second metal layer (4) is laid on this other surface side of the ceramic layer (2), and that then this second metal foil or blank (4') is bonded to the ceramic layer (2) and at the same time the metal body (8, 8') is bonded to the metal layers (3, 4) on both surface sides of the ceramic layer (2), in a further direct bonding process.

4. Process according to one of claims 1 - 3, characterised in that a metal body (8, 8') is inserted into each window (6) of several openings or windows (6) in the ceramic layer (2) to form several through connections (5), preferably by distributing these metal bodies over the openings (6) by means of a shaking or vibration technique and/or the use of distribution or stripping elements.

5. Process according to one of claims 1 - 4, characterised in that the metal is copper and/or that the reactive gas is oxygen.

6. Process according to one of claims 1 - 5, characterised in that the metal bodies (8, 8') are designed as round blanks, cuboid or as balls.

7. Process according to one of claims 1 - 6, characterised in that the dimensions of the metal bodies (8, 8') are chosen in such a way that the height of the metal bodies (8, 8') is the same or slightly larger than the thickness of the ceramic layer (2) .

8. Method according to one of claims 1 - 7, characterised in that the ceramic layer (2) is an aluminium oxide ceramic or an aluminium nitride ceramic, which is pre-oxidised on its surface sides.

9. Process according to one of claims 1 - 8, characterised in that the metal body (8, 8') is permanently deformed before and/or after insertion in a window (6), to a dimension which corresponds to the thickness of the ceramic layer (2).

10. Ceramic/metal substrate with at least one through connection, characterised by the fact that it is manufactured with at least one solid through connection using the process according to one of claims 1 to 9.

## Revendications

1. Procédé de fabrication d'un substrat métal-céramique, qui comprend au moins une couche céramique (2) et au moins deux couches métalliques (3, 4) prévues sur respectivement une surface de la couche céramique (2) et présente au moins une connexion transversale électrique (5) sur laquelle les couches métalliques (3, 4) sont reliées électriquement entre elles par un pont (7) dans la zone d'une ouverture ou d'une fenêtre (6) dans au moins la couche céramique (2), procédé avec lequel des feuilles ou des platines métalliques (3', 4'), dont les surfaces sont formées d'un composé chimique du métal avec un gaz réactif, sont fixées au moyen du procédé de bonding direct sur les surfaces d'au moins la couche céramique (2) pour la formation des couches métalliques (3, 4), et avec lequel, pour la préparation de la connexion transversale (5), on introduit dans l'ouverture et au moins la fenêtre (6) un métal formant le pont (7) au moyen duquel les couches métalliques (3, 4) sont reliées électriquement entre elles au moyen du procédé de bonding direct, caractérisé en ce qu'on insère dans au moins l'ouverture (6) un corps métallique (8, 8') qui la remplit complètement ou presque complètement et est pourvu à sur surface également d'une couche à base du composé chimique comprenant le métal et le gaz réactif.

2. Procédé selon la revendication 1, caractérisé en ce que, pour la fixation d'au moins une feuille ou une platine métallique (3', 4'), la liaison du corps métallique (8, 8') se fait en même temps avec au moins l'une des deux couches métalliques (3, 4).

3. Procédé selon la revendication 1 ou 2, caractérisé en ce qu'on fixe d'abord une feuille ou platine métallique (3') sur une surface de la couche céramique (2), en ce qu'ensuite au moins un corps métallique (8, 8') est inséré dans au moins la fenêtre ou dans au moins l'ouverture (6) par l'autre surface de la couche céramique (2), en ce qu'on applique ensuite une deuxième feuille ou platine métallique (4') formant la deuxième couche métallique (4) sur cette autre surface de la couche céramique (4), et ce qu'alors, dans un deuxième procédé répété de bonding direct, on relie cette deuxième feuille ou platine métallique (4') à la couche céramique (2) et en même temps le corps métallique (8, 8') aux couches métalliques (3, 4) sur les deux surfaces de la couche céramique (2).

4. Procédé selon l'une quelconque des revendications 1 à 3, caractérisé en ce que, avec plusieurs ouvertures ou fenêtres (6) dans la couche céramique (2), on introduit un corps métallique (8, 8') dans chaque fenêtre (6) pour la formation de plusieurs connexions transversales (5), et ce de préférence par une répartition de ces corps métalliques entre les ouvertures (6) au moyen d'une technique avec secousses ou vibrations et/ou en utilisant des éléments répartiteurs ou des éléments racleurs.

5. Procédé selon l'une quelconque des revendications 1 à 4, caractérisé en ce que le métal est du cuivre et/ou le gaz réactif est de l'oxygène.

6. Procédé selon l'une quelconque des revendications 1 à 5, caractérisé en ce que les corps métalliques (8, 8') se présentent sous la forme de rond, de parallélépipède ou de billes.

7. Procédé selon l'une quelconque des revendications 1 à 6, caractérisé en ce que les corps métalliques (8, 8') sont choisis dans leurs dimensions de telle façon que la hauteur des corps métalliques (8, 8') est égale ou légèrement supérieure à l'épaisseur de la couche de céramique (2).

8. Procédé selon l'une quelconque des revendications 1 à 7, caractérisé en ce que la couche céramique (2) est une céramique d'oxyde d'aluminium ou une céramique de nitrure d'aluminium qui est pré-oxydée sur leurs surfaces.

9. Procédé selon l'une quelconque des revendications 1à 8, caractérisé en ce que le corps métallique (8, 8') est déformé en permanence avant et/ou après l'insertion dans une fenêtre (6) jusqu'à une dimension correspondant à l'épaisseur de la couche céramique (2).

10. Substrat métal-céramique avec au moins une connexion transversale, caractérisé par sa fabrication avec au moins une connexion transversale massive en utilisant le procédé selon l'une quelconque des revendications 1 à 9.
